# DEMANDE DE BREVET EUROPEEN

(11) **EP 1 520 913 A1**
(43) Date de publication de la demande: **06.04.2005**
(21) Numéro de dépôt: 03293347.5
(22) Date de dépôt: 29.12.2003
(51) Int. Cl.: C23C 14/16, C23C 14/08, C23C 14/24

(54) **Procédé d'élaboration de matériaux microstratifiés thermostables**

(30) Priorité: 23.09.2003 CH 16222003
(71) Demandeur: GBA S.A., 1820 Montreux (CH)
(72) Inventeur: Hrechaniuk, Mikola, Kyiv 02154 (UA)
(74) Mandataire: Faber, Jean-Paul

(57) **Abrégé**

Procédé d'élaboration de matériaux microstratifiés thermostables dans lequel on chauffe un support, entraîné en rotation, destiné à recevoir lesdits matériaux, ceux-ci étant vaporisés sous vide à partir d'un creuset et condensés à la surface dudit support pour présenter une épaisseur de l'ordre de 0,1 à 1 µm, caractérisé en ce qu'il consiste à amener le support à une température égale ou supérieure de 0,3 par rapport à la température de fusion du matériau de la couche la moins réfractaire, et à former une interface de transition des matériaux de couches alternées d'une épaisseur de l'ordre de 0,001 à 0,05 µm avec une transition homogène de concentration d'une couche à l'autre.

## Description

La présente invention est relative à l'élaboration sous vide de composites possédant des propriétés physiques et mécaniques particulières et qui peuvent être utilisés dans la construction et la création des matériaux spéciaux réfractaires employés, par exemple, pour la protection des véhicules aérospatiaux, la fabrication des aubes des moteurs à turbine, des revêtements protecteurs contre l'oxydation à haute température, des matériaux spéciaux pour les contacts électriques, etc.

On accorde de plus en plus d'attention aux matériaux composites possédant des propriétés physiques et mécaniques particulières. Les matériaux renforcés (armés) peuvent être divisés en deux groupes fibreux (armés, renforcés par les fibres) et stratifiés (multicouches).

Les matériaux stratifiés ont certains avantages sur les matériaux fibreux, car ils offrent la possibilité de régler les caractéristiques physiques et mécaniques, à savoir :
1. Lors de la réalisation de matériaux fibreux armés, il est difficile de créer une surface extérieure particulière de la pièce, alors qu'il est connu que l'état et les propriétés des couches superficielles jouent un rôle décisif sur le comportement des matériaux. De plus, par la voie du changement de l'alternance et de l'épaisseur des couches, on peut faire varier les propriétés mécaniques d'un matériau stratifié en fonction de l'épaisseur des couches.
2. A la même proportion volumétrique des couches, la régularité de déformation des matériaux stratifiés s'est avérée plus haute que celle des matériaux fibreux.
3. La technologie de la fabrication des matériaux stratifiés est plus simple que celle des matériaux fibreux.

Les matériaux composites stratifiés industriels sont fabriqués par divers procédés ; les principaux sont :
- des assemblages de bandes, plaques, feuilles métalliques, tôles en divers métaux par laminage à chaud ;
- le coulage du métal liquide par plaques dures avec laminage postérieur des coulées ;
- le soudage par explosion ;
- la brasure forte ;
- la cristallisation eutectique orientée.

La description détaillée des procédés comme celle de certaines propriétés physiques et mécaniques des matériaux stratifiés sont présentées dans les exposés suivants et les monographies jointes.

Les compositions eutectiques réfractaires du type stratifié sont utilisées de plus en plus pour fabriquer des pièces de moteurs aéronautiques modernes.

Lesdits matériaux ont certains avantages par rapport aux matériaux monocouches, par exemple, ils ont des valeurs supérieures de résistance, de réfractabilité, de résistance au choc, etc.

Dans la plupart des cas, l'épaisseur d'une couche de matériaux fibreux est trois fois supérieure à l'épaisseur moyenne des grains.

La limite de résistance de tels matériaux peut atteindre la limite inférieure de la résistance théorique du métal. Dans les publications techniques des matériaux stratifiés (multicouches), ces matériaux sont nommés microstratifiés (MMS).

Les études des matériaux microstratifiés basées sur Cu, Pb, Sn, Cr, Fe, Ni, Mg, Au, Ag, C, Al₂O₃, ayant une épaisseur de 0,1 µm et moins, élaborés par un procédé d'étirage du faisceau de fils, du laminage du paquet de feuilles métalliques, ont été exécutées par V.S. Kopan. Il a montré que l'un des facteurs principaux de commande programmable des propriétés des matériaux composites microstratifiés (MCMS) correspond à l'épaisseur d'une couche. En règle générale, en fonction de la diminution de l'épaisseur, la microdureté, les limites de résistance d'élasticité, la force thermo-électromotrice induite par la déformation, la résistance électrique, la force coercitive, la continuité et la résistance à la fissuration s'accroissent.

La technologie à faisceaux d'électrons ouvre des possibilités pratiquement illimitées dans la construction des matériaux microstratifiés.

Le perfectionnement des procédés et des techniques de la condensation des substances sous vide, et avant tout la réalisation des vaporisateurs puissants à faisceaux d'électrons et des systèmes à magnétrons, permet d'élaborer les nouveaux matériaux ayant des structures de différents types et des épaisseurs variées.

On peut distinguer deux classes de matériaux microstratifiés élaborés par voie du dépôt des substances sous vide :
a) Les condensats microstratifiés (CMS) ont une épaisseur de 0,1 à 10 µm. La structure de l'interface des couches de différents matériaux est rassemblée au joint à grand angle de grains dans les polycristaux ;
b) Les condensats microstratifiés avec des couches ultraminces (de 6-8x10⁻¹⁰ à 6-8x10⁻⁸ m). En fonction de la structure des matériaux des couches alternées, la conjugaison des plans atomiques des réseaux cristallographiques des couches voisines (successives) a lieu au joint cohérent ou par formation du système unifié des plans atomiques.

La technique de la vaporisation et de la condensation sous vide des matériaux métalliques ou non métalliques permet de réaliser deux approches caractéristiques de la formation de la structure des condensats microstratifiés :
1. De faire condenser à des températures relativement basse et en conséquence d'obtenir des condensats ayant une grande densité d'irrégularité de réseaux cristallographiques de chacune des couches.
2. D'obtenir des condensats microstratifiés ayant une structure bien équilibrée par voie de la condensation aux températures dépassant de 0,3 la température de fusion (°C).

Les premiers travaux sur les condensats microstratifiés déposés selon un premier mode, on été exécutés dans les années 1964 à 1966 à l'Institut Polytechnique de Kharkiv sous la direction de L.S. Palatnyk. La modification de la structure et des propriétés physiques et mécaniques des matériaux microstratifiés condensés dudit type a été faite par A.I. Illinsky. Les études ont été exécutées sur les condensats (CMS) Cu/Cr, Ni/Si avec une teneur en volume des couches de renfort (jusqu'à 10%), l'épaisseur ne dépassant pas µm.0,1 L'épaisseur totale des couches des CMS étudiées n'était plus que de 50 à 100 µm. Pour les CMS comme pour les matériaux microstratifiés obtenus par les procédés traditionnels, on a noté un renforcement important avec la diminution de l'épaisseur des couches. On a montré que ledit effet de dimension est notamment causé par l'influence des interfaces de phases. Par la variation de la surface totale des interfaces de phases, on peut obtenir l'accroissement de la résistance, ceci est démontré dans l'exemple de CMS Cu/Cr.

Les compositions microstratifiées concernées maintiennent la stabilité de la structure et un haut niveau de caractéristiques mécaniques à des températures de l'ordre de 400 à 500°C. A des températures plus hautes des discontinuités (désintégration) des couches alternées des fragments séparés et la création de la structure typique à phases hétérogènes ont lieu. Les structures et propriétés des matériaux microstratifiés condensés, l'épaisseur des couches alternées (composants) de plus de 0,1 µm, ont été peu étudiées. Dans les publications spécialisées, on trouve seulement des renseignements particuliers concernant les CMS Cu/Fe, Ag/Ni, Cu/Cr, déposés à la température du support ne dépassant pas de 300°C.

Les caractéristiques ci-dessus exposées concernant les matériaux microstratifiés déposés sous vide montrent qu'on n'a étudié qu'une petite partie des CMS déposés à des températures relativement basses (pas plus de 300°C).

Les inventeurs ont plus particulièrement effectué des études visant des matériaux microstratifiés, élaborés à des températures du support de 500 à 1000°C. On a étudié les types de matériaux microstratifiés Fe/Cu, Cr/Cu, Ni/Cu, Mo/Cu, NiCrAlY/NiCrAlY-Al₂O₃, NiCrAlY/NiCrAlY-(ZrO₂+Y₂O₃), Ti/TiAl, Ti₃Al/TiAl, Ti4V6Al/TiAl etc. Les matériaux microstratifiés ont été fabriqués à partir des pièces brutes de tôle de dimensions de 250x350x0,5 mm et de 1,5 mm d'épaisseur, les couches alternées ayant une épaisseur de 0,1 µm à 30 µm, on a ensuite coupé les échantillons pour des essais mécaniques et des études physiques et chimiques.

Les figures jointes représentent les différents éléments suivants :
Figure 1 montre une microstructure de type CMS avec une épaisseur d'une microcouche unitaire de 1 µm environ.
Figure 2 montre la décomposition des couches CMS à environ une température de 650°C, l'épaisseur de la couche étant de 1 µm.
Figure 3 montre la répartition des molécules à partir de la vaporisation de deux sources sur un support fixe.
Figure 4 montre la répartition des molécules à partir de la vaporisation de deux sources sur un support tournant.
Figure 5 montre en plan, la répartition des molécules à partir de la vaporisation de deux sources sur un support tournant.
Figure 6 montre la microstructure du CMS déposé sur un support ondulé.
Figure 7 montre la microstructure du CMS déposé sur un support à ondulations avec des petits rayons de courbure.
Figure 8 montre la microstructure du CMS déposé sur un support dont la surface est crénelée.
Figure 9 montre la microstructure du CMS déposé sur un support dont la surface est crénelée.
Figure 10 montre un défaut de la structure du CMS.
Figure 11 montre un défaut de la structure du CMS engendré par un dépôt par gouttes lors de la vaporisation du matériau de la couche interfaciale.
Figure 12 montre un défaut de la structure du CMS engendré par le transfert par gouttes lors du dépôt initial.
Figure 13 montre un défaut de la structure du CMS engendré par le transfert par gouttes au départ du processus.
Figure 14 montre la structure d'un matériau microstratifié cuivre/molybdène (épaisseur des couches cuivre 0,3 µm et molybdène 0,2 µm).
Figure 15 montre la structure du CMS cuivre/molybdène (état initial - épaisseur des couches cuivre 0,4 µm, 0,5 µm, molybdène 0,15, 0,2 µm).
Figure 16 montre la structure cuivre/molybdène après retrait sous vide et soumise à une température de 900°C durant une heure (épaisseur des couches : cuivre 0,3 µm et molybdène 0,2 µm).

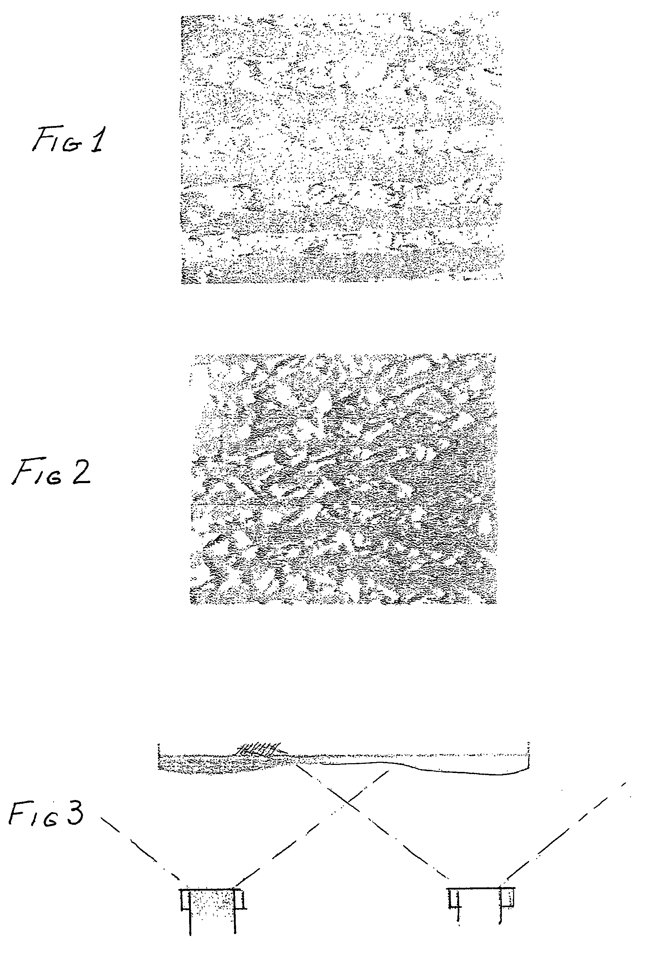

Les compositions de modèles les plus proches en matière technique de la présente invention sont les suivantes : Fe/Cu, Cr/Cu et Ni/Cu, déposées à la température du support ≈0,45 de la température de fusion (°C) de la couche la moins réfractaire (difficilement fusible) et on a montré que par un choix approprié des matériaux pour les couches alternées de l'épaisseur, on pourra obtenir avec une haute stabilité de la structure, des valeurs de la résistance et de l'élasticité situées dans des gammes élevées, des basses valeurs de fluage à haute température et des basses valeurs de thermoconductibilité. En général, la limite de résistance δ_{B} et la limite d'écoulement δ₀₂ des matériaux microstratifiés étudiés peut dépasser les valeurs correspondantes δ_{B} et δ₀₂ des matériaux des couches particulières de 1,5 à 4 fois des épaisseurs des couches alternées, de moins de 2 µm. L'allongement relatif du CMS a tendance à diminuer et approche de la valeur zéro pour des couches alternées dont l'épaisseur est inférieure à 1 µm. On a également étudié la structure, la composition de phases et les propriétés physiques et mécaniques d'une nouvelle classe de matériaux condensés métal/métal-céramique : NiCrAlY/NiCrAlY-Al₂O₃, NiCrAlY/NiCrAlY-(ZrO₂+y₂O₃) dans la gamme des épaisseurs de 0,2 à 25 µm, avec une teneur en oxyde dans les couches de métal-céramique de 0 à 50% mas. On a établi, que le facteur principal déterminant la variation des propriétés des matériaux microstratifiés est la teneur en oxyde dans les microcouches de métal-céramique. A la concentration de l'oxyde de 0,5 à 4% et des microcouches de l'épaisseur de 1 à 25 µm, les valeurs de la résistance et de l'élasticité des matériaux microstratifiés sont de 10 à 20%, la résistance à la chaleur est de 5 à 30% supérieure à celle des alliages maîtres. La structure de tels matériaux est montrée à la figure 1.

Pour tous les types de CMS qui ont été déposés à une température supérieure à 0,3 de la température de fusion (°C) du matériau de la couche la moins réfractaire (difficilement fusible), on constate une décomposition des couches dont l'épaisseur unitaire est inférieure à 1 µm (Figure 2).

Ainsi, on peut tirer la conclusion générale que dans les publications scientifiques, on n'a pas d'informations concernant les matériaux microstratifiés dont l'épaisseur de la couche est inférieure à 1 µm et qui ont été élaborés à une température supérieure à 0,3 de la température de fusion (°C) du matériau de la couche la moins réfractaire. Par un choix approprié des composants des couches alternées et de la température de dépôt, on pourra, par analogie avec d'autres types de CMS, faire varier dans une gamme étendue les propriétés physiques et mécaniques du support. Il est logique de supposer que les matériaux microstratifiés élaborés aux hautes températures du support pourront se distinguer de tous ceux connus par un niveau plus haut de la thermostabilité de la structure. Les matériaux condensés aux hautes températures du support sont irremplaçables pour la construction d'alliages spéciaux résistant aux hautes températures pour les industries aérospatiale, électronique et électrotechnique et pour la réalisation de revêtements à destination spéciale.

Comme déjà mentionné ci-dessus, les tentatives pour élaborer les matériaux microstratifiés avec une épaisseur des couches alternées de moins de 0,5 à 1 µm pour des températures du support supérieures de 400 à 500°C, ont été confrontées à des difficultés liées à la décomposition des couches.

L'invention vise à réaliser des matériaux microstratifiés dont l'épaisseur des couches est de 0,1 à 1 µm, à une température du support supérieure ou égale à 0,3 de la température du fusion (°C) du matériau de la couche la moins réfractaire. La stabilité de la structure des couches alternées est obtenue par la formation à l'interface de couches de transition des matériaux des couches alternées, d'épaisseur de 0,001 à 0, 005 µm, avec une transition homogène de concentration du matériau d'une couche au matériau d'une autre couche. On obtient ainsi une stabilité supplémentaire par voie de l'oxydation programmée des composants formant les microcouches. La oncentration des oxydes dans la zone de transition ne dépasse pas 3 à 5%. Simultanément à la formation des oxydes, les siliciures se forment aussi à l'interaction des composants carburigènes des couches avec les vapeurs de l'huile des pompes à vide, la concentration de celles-ci ne dépasse pas de 2 à 4%.

On a constaté que la formation de la structure microstratifiée stable est possible aux conditions suivantes :
1. La distance à la surface condensatrice doit être égale à 0,55 à 0,8 de la distance entre les centres des creusets à partir desquels les composants sont vaporisés.
2. La distance entre les centres des creusets doit être égale à 0,55 à 0,8 du diamètre du support.
3. La vitesse de rotation du support en unités relatives ne doit pas dépasser de plus 3 à 5 fois la vitesse du dépôt du flux vaporisé (par exemple, la vitesse du dépôt du flux vaporisé de cuivre et de molybdène est de 10 µm/min - la vitesse de rotation du support doit être de l'ordre de 30 tour/min).
4. Le niveau de la rugosité du support dont la surface doit permettre de condenser le flux ne doit pas dépasser 0,63 R_{A}.
5. La température du support doit être dans la gamme de 0,3 à 0,8 de la température de fusion (°C) du métal (alliage) le moins réfractaire (difficilement fusible) qui est vaporisé.

Les figures 3, 4 et 5 illustrent la répartition des atomes (molécules) vaporisés (par exemple de cuivre et de molybdène) sur un support dans la surface constitue un condensateur, celle-ci étant calculée conformément à la loi cosinusoïdale de répartition proposée par Knudsen. Ladite loi vérifiée par un grand nombre de chercheurs, décrit assez précisément la répartition des atomes (molécules) sur le support lors de la vaporisation d'une substance de la source ponctuelle.

Sur les figures 3, 4 et 5, on peut voir qu'avec une disposition géométrique donnée des creusets (pris au calcul pour les sources ponctuelles de la vaporisation) et du support, certaines zones reçoivent seulement l'un des matériaux. La densité de concentration des atomes (molécules) du cuivre et du molybdène est diminuée en fonction de l'augmentation du diamètre du support. En conséquence, dans une zone particulière du support, des flux du cuivre et du molybdène vaporisés se mêlent et une couche de transition se forme entre les composants formant le condensat. Sur les figures 3, 4 et 5, on peut également voir qu'il y a des zones de densité minimale de la concentration des atomes de cuivre et de molybdène. Dans ces zones, on peut probablement voir la formation d'oxydes et de carbures des matériaux vaporisés à la suite de leur interaction avec les vapeurs de l'huile (carbone) des pompes à vide et de l'atmosphère de la chambre de travail (oxygène). On a ainsi établi que la teneur totale en oxydes, en carbures et en autres composés réfractaires dans les matériaux condensés ne dépassent pas 5 à 8% mas. Le type des composés formés et leur nombre dépendent du type des matériaux vaporisés, du niveau de vide, de la vitesse du pompage et de la vitesse de l'entrée des gaz résiduels de l'atmosphère. La présence des particules dispersées des oxydes et des carbures de taille de 100 à 200 A° (de 0,0001 à 0,0002 µm) notamment dans l'interface de transition entre les couches, contribue à la stabilité thermique des couches formées, au ralentissement des processus de diffusion des couches engendrant leur décomposition.

La création de la structure microstratifiée sur un support fixe (figure 3) est impossible parce que les zones du mélange des flux des matériaux vaporisés restent pratiquement invariables. Dans ces conditions, il est formé un condensat avec un passage de 100% du composant A à 100% du composant B.

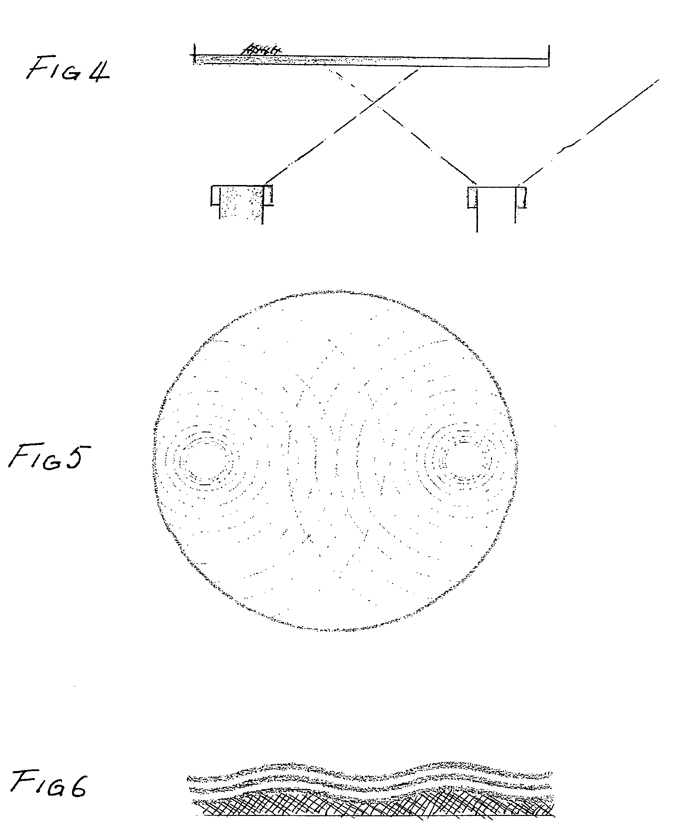

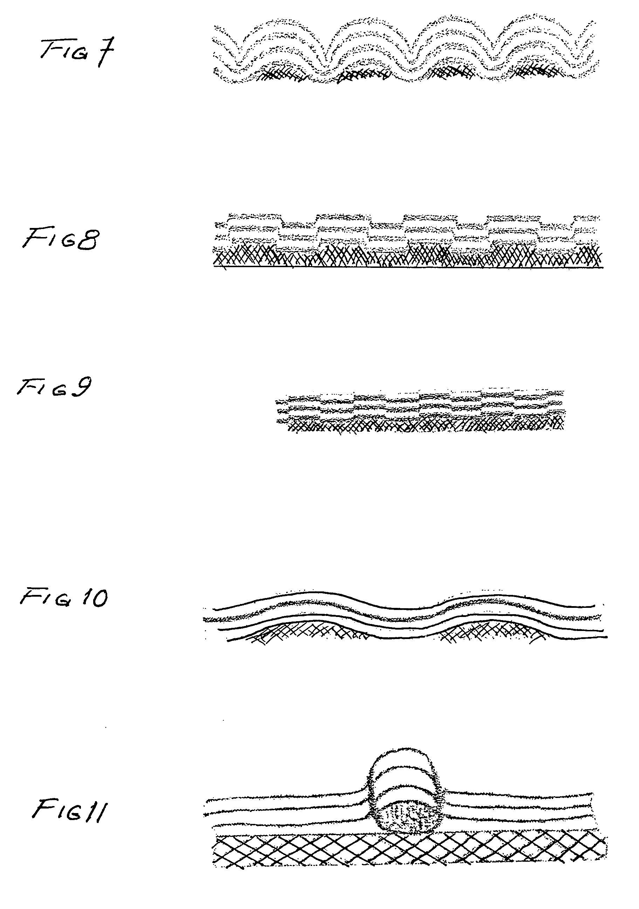

On observe une grande différence lorsque le support est entraîné en rotation (figures 4 et 5). Dans ce cas les zones périphériques du support, en tournant, sont exposées au flux du composant vaporisé A, au flux des composants (A + B) et (B + A) et ensuite au flux du composant B. La superposition des flux vaporisés des composants A->A + B->B + A->B ainsi que l'épaisseur des microcouches alternées dépendra des paramètres technologiques de l'élaboration d'un matériau, de la vitesse de vaporisation des matériaux appropriés, et de la vitesse de rotation du support. L'augmentation ou la diminution de la vitesse de rotation du support entraîne obligatoirement l'augmentation ou la diminution de l'épaisseur des couches des composants A et B alternées.

On peut obtenir une variation réglée de l'épaisseur des couches alternées pas seulement par la variation de la vitesse de rotation du support, mais par la régulation des vitesses de vaporisation des composants. Il est facile de faire varier l'épaisseur des couches des composants A et B alternées, en fonction du condensat formé. Ceci a une grande importance, par exemple, pour la formation des condensats dans lesquels le composant A est un métal (alliage) et le composant B est un oxyde, composé semblable au métal.

Avec l'utilisation de trois creusets ou plus, il est possible d'implanter dans une couche ou dans deux couches alternées, des inclusions dispersées d'une phase difficilement fusible dans le but d'améliorer les caractéristiques physiques et mécaniques et la stabilité thermique du matériau dans son ensemble. L'utilisation du présent procédé ouvre des possibilités pratiquement illimitées pour la création de matériaux nouveaux ayant un ensemble déterminé de propriétés physiques et mécaniques.

Comme on l'a mentionné ci-dessus, l'élaboration de matériaux ayant une structure microstratifiée de ce type n'est possible qu'en fonction de certaines conditions techniques.

En premier lieu, il faut tenir compte de la distance de la surface condensatrice qui doit être égale à 0,55 à 0,8 de la distance entre les centres des creusets à partir desquels s'effectue la vaporisation. Ces impératifs sont montrés sur la figure 5. Une diminution de la distance du support par rapport aux creusets, conformément à la loi cosinusoïdale de répartition du flux entraîne une zone de coupure des flux diminuée. Une augmentation de la distance entre les creusets et le support est inutile parce que le coefficient de vaporisation est brusquement diminué. Par exemple, la condensation des flux de cuivre et du molybdène sur un support de diamètre de 1000 mm à la distance entre les centres des creusets de 650 mm et à la distance du support de 450 mm, le coefficient de l'utilisation du flux vaporisé est de 0,58 à 0,62.

Une deuxième condition est que la distance entre les centres des creusets doit être égale à 0,55 à 0,8 de diamètre du support dont la surface est condensatrice. Une diminution de la distance entre les creusets engendre une plus grande zone d'interférence (du mélange) des flux. Proportionnellement à sa taille, l'épaisseur de l'interface de transition sera augmentée et l'épaisseur des couches alternées sera diminuée ce qui entraîne la diminution de la stabilité de la structure des couches ou sa disparition presque totale.

Une distance entre les centres des creusets de plus de 0,8 du diamètre du support est pratiquement impossible à cause de l'absence d'interférence (du mélange) des flux. La non existence d'une interface de transition stable entraîne aussi la décomposition des couches.

Une troisième condition est que la vitesse relative du support doit dépasser de 3 à 5 fois la vitesse sommaire du dépôt du flux vaporisé. Pour la disposition géométrique susmentionnée des creusets, la vitesse relative comparée de rotation du support (par exemple, de 10 tour/min), le dépôt du flux vaporisé sera de l'ordre de 10 µm/min, l'épaisseur de chacune des couches alternées pour une vitesse de dépôt approximativement égale des composants A et B, sera de 1 µm environ, c'est-à-dire dix fois moins en valeur relative que la vitesse de rotation du support et la vitesse de dépôt des composants A et B.

Pour diminuer l'épaisseur des couches alternées, il est nécessaire :
a) d'augmenter la vitesse de rotation du support ;
b) de diminuer la vitesse sommaire de dépôt du flux vaporisé.

Il est préférable d'augmenter la vitesse de rotation du support car elle est plus économique.

Une quatrième condition est le niveau de rugosité du support dont la surface ne doit pas dépasser 0,63 R_{A}.

Les figures 6, 7, 8, 9 illustrent les divers niveaux de rugosité qui peuvent être formés lors de la préparation de la surface condensatrice du support.

Parce que le flux concentré vaporise le profil de la surface condensatrice du support, la forme de la rugosité influe essentiellement sur la stabilité des microcouches alternées et sur les caractéristiques mécaniques du matériau dans son ensemble. Le profil idéal serait l'obtention d'une surface pratiquement plane ce qui est pratiquement possible, mais économiquement inutile à la production des matériaux de ce genre en échelle industrielle.

Le traitement de surface le plus admissible est présenté par la figure 6. Dans ce cas, l'ondulation des couches des composants A et B n'influe pratiquement pas sur les caractéristiques mécaniques des matériaux microstratifiés. Une variation du niveau des ondulations, comme celle de la figure 7 peut éventuellement engendrer des perturbations de stratification (discontinuité des couches) et l'apparition de concentration dans les cavités qui finalement amène à la réduction des caractéristiques mécaniques d'un matériau.

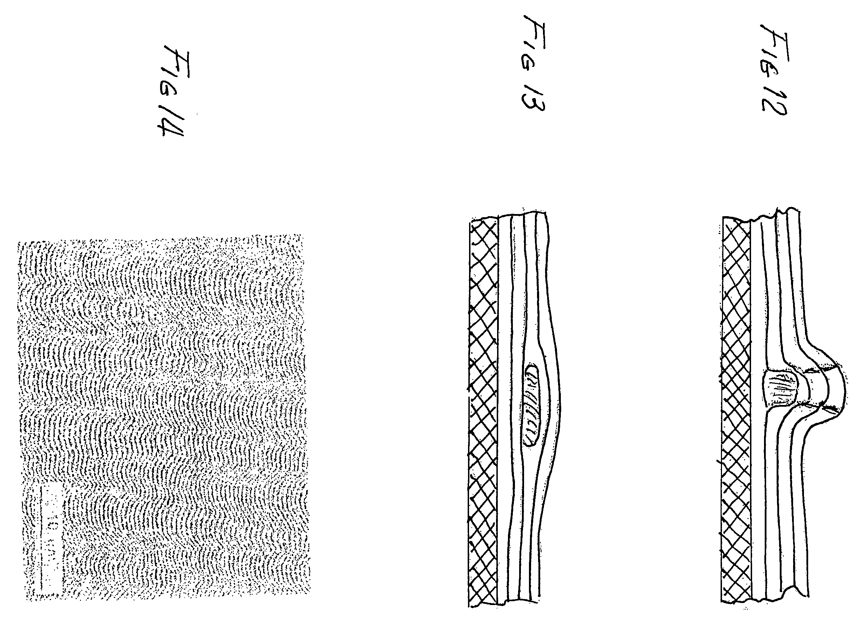

En général, si les différences de niveau dans la surface du support sont égales ou supérieures à l'épaisseur du microstratifié, celui-ci ne peut présenter une bonne continuité (figures 8, 9).

Sur les surfaces latérales des côtés sous un angle proche de 180° (figures 8, 9), le condensat est sous forme de poudre ce qui entraîne une fracture du condensat dans son épaisseur. Ces formes de surface ne peuvent être retenues pour l'obtention de matériaux microstratifiés.

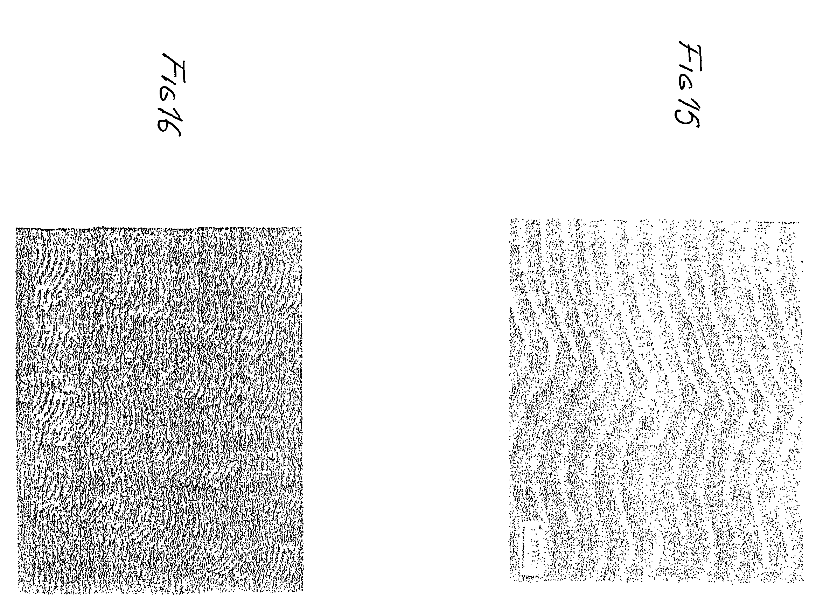

Les propriétés physiques et mécaniques des condensats dépendent en grande partie des défauts de structure du matériau engendrés par :
a) la séparation rapide au cours du processus de la vaporisation des matériaux de départ (figure 10) ;
b) la formation de gouttes lors de la formation de la couche d'interface (figure 11) ;
c) la formation de gouttes au début du processus (figures 12, 13).

Les défauts les plus graves sont ceux qui sont formés lors des étapes initiales, c'est-à-dire lors de la formation de la sous-couche interfaciale (figure 11) et pendant les premières minutes de la formation du matériau 1 microstrafifié lui-même (figure 12). Les micro-grouttes formées au dépôt de la couche interfaciale (par exemple à la vaporisation CaF₂) ou les micro-gouttes formées sur le support au moment initial de la vaporisation des matériaux de départ engendrent des parties en forme de barrettes ou d'aiguilles (figures 10, 11) qui ne sont pas liées au matériau principal et dans toute l'épaisseur du condensat. Lesdites barrettes causent la détérioration rapide du matériau à des charges mécaniques minimales.

Un feuilletage éventuel du matériau condensé peut se produire avec une séparation rapide du matériau du support. Dans ce cas, l'arrêt temporel d'amenée du flux au support est réalisé, les couches supérieures du condensat sont oxydées et des oxydes de carbures se forment à cause de la présence de l'atmosphère résiduelle et des vapeurs de lubrifiants dans la chambre de travail de l'installation. La figure 10 montre ledit feuilletage par la ligne foncée.

La formation de la couche interfaciale d'oxycarbure (borure) avec une séparation à court terme est aussi possible à cause de la couverture de la surface du bain liquide par un film d'oxydes, carbures, borures contenus dans le produit coulé.

Le feuilletage entre couches ne se produit pas sur tout le périmètre du condensat, mais seulement dans des secteurs particuliers.

Le niveau de la rugosité, la forme des microaspérités de la surface ainsi que la pureté des pièces de coulées de départ (à vaporiser) ont un effet sur la formation de la structure microstratifiée et les caractéristiques physiques et mécaniques du condensat dans ensemble.

La température du support dont la surface est condensatrice, doit être dans la gamme de 0,3 à 0,8 de la température de fusion (°C) du métal (alliage) le moins réfractaire (difficilement fusible) qui est vaporisé.

L'étude de la structure des condensats de certains métaux et oxydes purs de 0,3 à 2 mm d'épaisseur, élaborés à l'aide de canons à faisceaux d'électrons, a permis de proposer un modèle de trois zones de structure des condensats épais. La première zone est à basse température, température inférieure à celle ambiante jusqu'à une température limite T₁, égale à 0,3 environ de la température de fusion (°C) de la substance condensée. Aux températures inférieures à T₁ la surface des condensats a une forme ondulée. La coupe du condensat montre les cristallites coniques. La combinaison des cristallites adjacentes est faite sans limites des cristallites nettes. A l'intérieur des cristallites, notamment dans les zones frontières, il y a les micropores. Les condensats obtenus aux températures inférieures à T₁ sont caractérisés par un bas niveau de la résistance et de l'élasticité. C'est pourquoi à la formation des matériaux microstratifiés condensés avec un niveau élevé de caractéristiques physiques et mécaniques, la température du support ne doit pas être inférieure à 0,3 par rapport à la température du fusion (°C) de la substance vaporisée.

La limite supérieure du chauffage du support est de 0,8 par rapport à la température de fusion (°C) de la substance condensée, cette substance est conditionnée du fait qu'à des températures plus hautes, le dépôt accru des cristallites est observé. Ainsi, la valeur de la résistance augmente essentiellement avec l'accroissement simultané de l'élasticité, et du point de vue de l'utilisation postérieure du matériau, ce n'est pas toujours utile et nécessaire.

On a particulièrement étudié la formation de la structure des matériaux microstratifiés thermostables, en particulier : Cu-Mo, Fe-Cu, Cr-Cu.

Les figures 14, 15 et 16 représentent les structures du type des matériaux microstratifiés condensés, par exemple, des composites Cu-Mo. Les condensats en forme de feuilles de 800 à 1000 mm de diamètre et de 0,5 à 4 mm d'épaisseur ont été élaborés à l'aide de l'installation industrielle à faisceaux d'électrons Y3-189. Le support dont la surface est condensatrice, a été préalablement chauffé à la température de 650±20°C. Pour facilement séparer le matériau condensé et le support, on a revêtu celui-ci par une couche mince (de 10 à 15 µm) de séparation de fluorure de calcium (CaF₂). Les figures 14, 15 et 16 montrent en foncé les couches du cuivre et en clair celles du molybdène. Les changements du profil des couches alternées indiquent les changements de la rugosité du support. On peut observer une légère ondulation des couches sans passages brusques (convexités-concavités), qui peuvent entraîner l'abaissement essentiel des caractéristiques mécaniques. L'épaisseur moyenne des couches du cuivre et du molybdène présentée à la figure 14 est respectivement de 0,3 et de 0,2 µm. A la figure 15, l'épaisseur des couches est de 0,4 à 0,5 et de 0,15 à 0,2 µm. Les couches alternées du cuivre et du molybdène sont sans ruptures et discontinuités visibles. La structure stratifiée des condensats Cu-Mo est maintenue même après un recuit sous vide à une température de 900°C pendant 3 heures (Figure 16).

Seulement dans des cas particuliers du condensat, on peut observer des discontinuités des couches à cause du commencement de leur décomposition. En tenant compte que la température de fusion du cuivre est de 1083,4°C, on peut noter le fait que les matériaux indiqués sont caractérisés par une thermostabilité très haute. Les structures de qualité semblable ont été aussi obtenues par les condensats Fe-Cu et Cr-Cu. Le tableau 1 représente certaines propriétés physiques et mécaniques des matériaux étudiés en état initial et après le recuit sous vide à 900°C durant 3 heures.

L'analyse des résultats représentés au tableau 1, montre que les matériaux microstratifiés Cu/Mo, malgré la présence de plus de 30% mas. du composant ont une relativement faible résistance et une haute élasticité (cuivre) et leur résistance mécanique, à la température d'ambiance, dépasse celle des composants de départ : le cuivre voisin de 4 fois, le molybdène voisin de 2 fois. Quant à la dureté, le CMS Cu/Mo dépasse celle du cuivre de 6,5 et du molybdène de 1,5. Le recuit des condensats sous vide à 900°C durant 3 heures entraîne la diminution de la résistance de 25 à 30% environ, avec l'accroissement de l'élasticité à 1,6 à 1,9 fois. Le recuit sous vide pratiquement n'influe pas sur la valeur de la densité et de la résistance électrique spécifique des condensats.

Il est intéressant de remarquer le fait que les valeurs de la résistance du CMS Cu/Mo à la température d'essai de 650°C sont comparables à la résistance du cuivre à la température ambiante.

Le tableau 2 représente certaines propriétés physiques et mécaniques des matériaux microstratifiés Fe/Cu, Ni/Cu et Cr/Cu à la température ambiante. Comme pour les condensats Cu/Mo, on peut noter l'accroissement de la résistance et de la dureté par rapport à la résistance et à la dureté des composants initiaux.

Ainsi, les résultats exposés ci-dessus et leur analyse montrent les importantes possibilités du procédé revendiqué pour la conception des matériaux microstratifiés nouveaux.

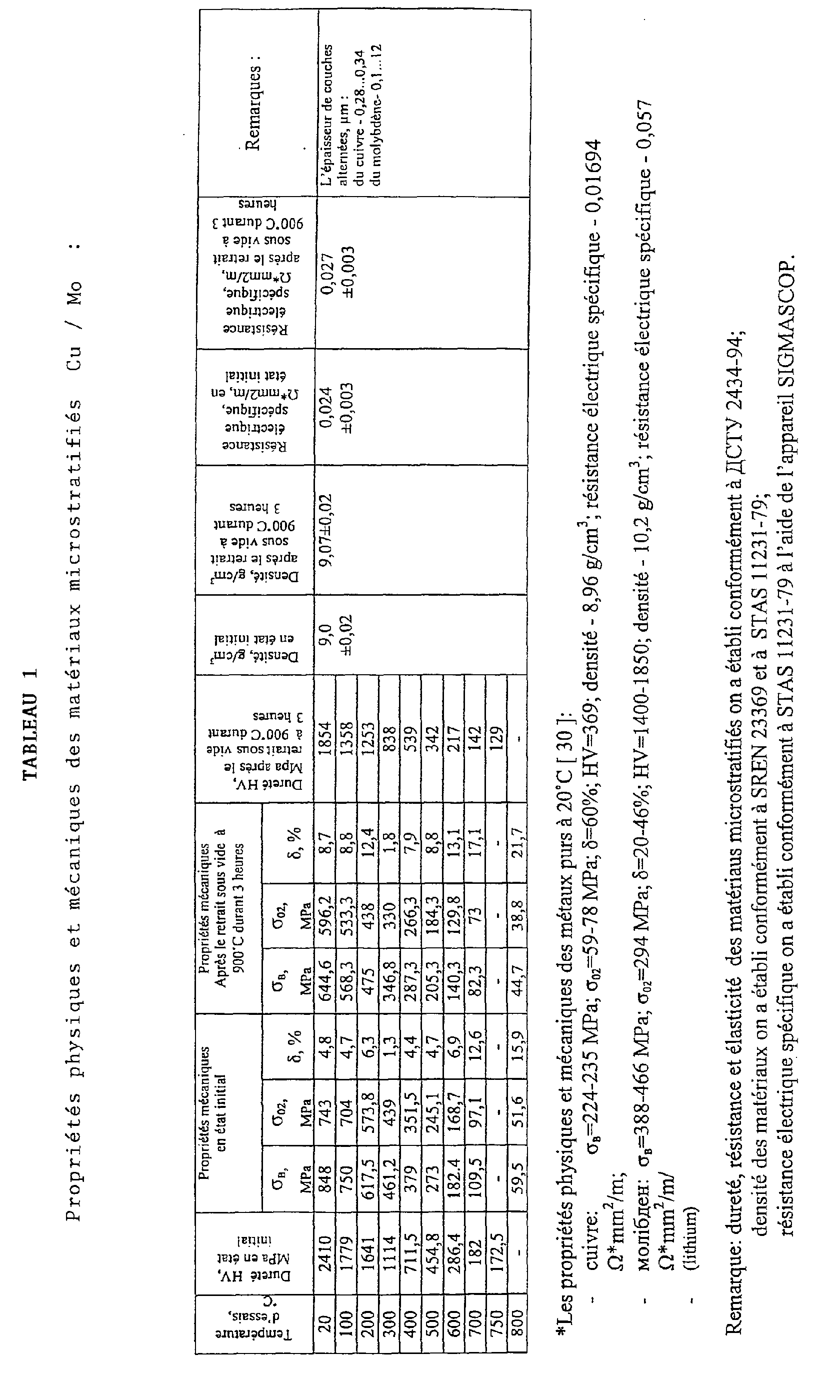

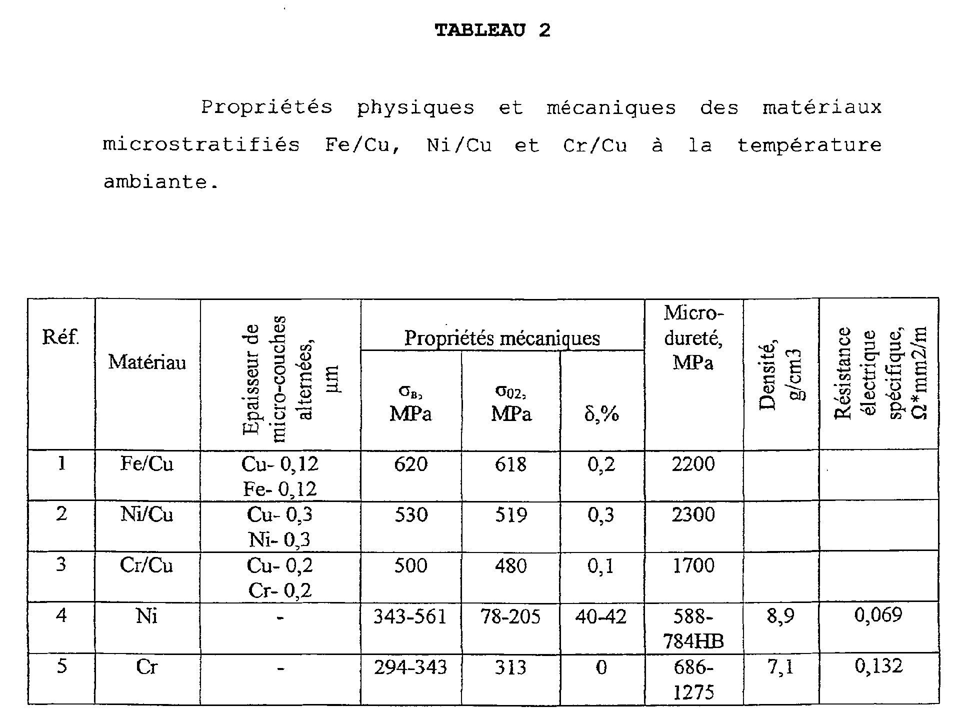

## Revendications

1. Procédé d'élaboration de matériaux microstratifiés thermostables dans lequel on chauffe un support, entraîné en rotation, destiné à recevoir lesdits matériaux, ceux-ci étant vaporisés sous vide à partir d'un creuset et condensés à la surface dudit support pour présenter une épaisseur de l'ordre de 0,1 à 1 µm, **caractérisé en ce qu'**il consiste à amener le support à une température égale ou supérieure de 0,3 par rapport à la température de fusion du matériau de la couche la moins réfractaire, et à former une interface de transition des matériaux de couches alternées d'une épaisseur de l'ordre de 0,001 à 0,05 µm avec une transition homogène de concentration d'une couche à l'autre.

2. Procédé d'élaboration de matériaux microstratifiés thermostables, selon la revendication 1, **caractérisé en ce que** l'on place le support à une distance du centre des creusets comprise entre 0,55 et 0,8.

3. Procédé d'élaboration de matériaux microstratifiés thermostables, selon les revendications 1 et 2, **caractérisé en ce qu'**on dispose le support à une distance des creusets de manière que celle-ci soit égale à 0,55 à 0,8 par rapport à la surface du support.

4. Procédé d'élaboration de matériaux microstratifiés thermostables, selon les revendications 1, 2 et 3, **caractérisé en ce qu'**on amène le support à une vitesse de rotation en unités relatives à 3 à 5 fois la vitesse sommaire de dépôt du flux vaporisé.

5. Procédé d'élaboration de matériaux microstratifiés thermostables, selon les revendications 1 à 4, **caractérisé en ce qu'**on réalise le support de manière qu'il présente une surface dont la rugosité est inférieure à 0,63 R_{A}.
